**Europäisches Patentamt**

**European Patent Office**

**Office européen des brevets**

(19)

(11) Veröffentlichungsnummer: **0 123 213**
**B1**

(12) # EUROPÄISCHE PATENTSCHRIFT

(45) Veröffentlichungstag der Patentschrift:
03.02.88

(51) Int. Cl.⁴: **H 04 B 15/00**, H 03 H 1/00

(21) Anmeldenummer: **84104084.3**

(22) Anmeldetag: **11.04.84**

(54) Elektrisches Entstörfilter.

(30) Priorität: **26.04.83 DE 3315036**

(43) Veröffentlichungstag der Anmeldung:
**31.10.84 Patentblatt 84/44**

(45) Bekanntmachung des Hinweises auf die Patenterteilung:
**03.02.88 Patentblatt 88/5**

(84) Benannte Vertragsstaaten:
**CH DE FR GB IT LI NL SE**

(56) Entgegenhaltungen:
**EP-A-0 025 367**
**DE-A-3 214 598**
**DE-B-1 616 408**
**US-A-2 148 984**

**SIEMENS "Technische Mitteilung aus dem Bereich Bauelemente", Dezember 1981, SIEMENS AG München; "Elektromagnetische Verträglichkeit durch den Einsatz von Entstörfiltern", Seiten 16-18**

(73) Patentinhaber: **Siemens Aktiengesellschaft Berlin und München, Wittelsbacherplatz 2, D-8000 München 2 (DE)**

(72) Erfinder: **Dirmeyer, Josef, Dipl.- Ing., D-8465 Bodenwöhr- Neuenschwand 64 (DE)**
Erfinder: **Kinzler, Hans, Dipl.- Ing., Roter Brachweg 69, D-8400 Regensburg (DE)**
Erfinder: **Lahner, Karl- Heinz, Fr.- Ebert- Strasse 43, D-8400 Regensburg (DE)**
Erfinder: **Schulz, Hans- Werner, Dipl.- Ing., Am Höllberg 9, D-8411 Wenzenbach (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft ein elektrisches Entstörfilter mit einem Filtergehäuse mit an Stirnenden herausgeführten elektrischen Anschlüssen, die aus Anschlußelementen, wie beispielsweise Flachsteckern, Anschlußlitzen, Stiftsteckern und dergleichen, bestehen und mit elektrischen Bauelementen, insbesondere Induktivitäten und Kapazitäten, die in das Filtergehäuse eingesetzt und an die elektrischen Anschlußelemente angeschaltet sind.

Die Entstörfilter der vorstehend genannten Art sind unter anderem für den Einsatz in Tischrechnern, Büromaschinengeräten und medizinischen Geräten bestimmt. Ihre wesentliche Aufgabe besteht dabei in der Verminderung leistungsgebundener Störpegel. Da diese Filter bedingt durch ihre Verwendungsart durch ihre Einsatzumgebung hohen elektrischen und magnetischen Feldstärkepegeln ausgesetzt sind, ist darauf zu achten, daß ihre Entstörwirkung durch elektrische und magnetische Einkoppelungen auf die Verdrahtung bzw. die Bauteile der Filterschaltung nicht gemindert wird. Insbesondere bei ihrem Einsatz in elektrischen Geräten mit Schaltnetzteilen und/oder Mikroprozessorsystemen mit ihren langen Busleitungen treten diese Probleme in hohem Maße auf. Soweit bereits Versuche unternommen wurden, um diese Probleme zu lösen, bestehen diese z. B. in der Verwendung allseitig geschlossener Metallgehäuse für die Entstörfilter, die isolierte Durchführungen für die Anschlüsse aufweisen. Als Metallgehäuse dienen dabei tiefgezogene Gehäuse aus Neusilber oder zweiteilige, dicht verlötete Gehäuse aus Eisenblech.

Bekanntgeworden sind solche Filter z. B. als Filter mit integriertem Kaltgerätestecker, bei denen die Anschlüsse von der Netzseite her über diesen Kaltgerätestecker - üblicherweise eine sog. Steckdose - und die Kontaktierung zum Gerät, das mit dem Filter zu versehen ist, über Flachstecker, Anschlußlitzen, Lötfahnen oder dergl. erfolgen. Verwiesen sei hierzu beispielsweise auf die unter dem Titel "Elektromagnetische Verträglichkeit durch den Einsatz von Entstörfiltern" von Siemens herausgegebene technische Mitteilung aus dem Bereich Bauelemente, Bestellnummer B/24 18, insbesondere Seite 18 und auf den unter der Bestellnummer B/22 84 erhältlichen Siemens-Werbeprospekt "Funk-Entstörfilter", Lieferprogramme 1980/81, Seite 12, 13.

In eine Halbschale aus Neusilberblech sind dabei die Anschlüsse und die Träger der elektrischen Bauelemente dicht eingeklebt. Die elektrischen Bauelemente an sich werden bei diesem Entstörfilter in der Halbschale montiert, isoliert und von Hand eingelötet. Anschließend werden die elektrischen Bauelemente von der offenen Seite der Halbschale her zuerst mit einem weichen Epoxidharzverguß fixiert und anschließend durch einen Hartverguß mechanisch geschützt.

Weitere, im Handel erhältliche Entstörfilter verwenden anstelle der Neusilber-Halbschale ein tiefgezogenes Neusilbergehäuse. Die Bauelemente werden dabei in einem Hilfsrahmen mit Flachsteckern montiert und gelötet. Das Vergießen der Bauelemente und der im Filtergehäuse befindlichen Flachsteckerteile erfolgt durch ein Loch im Neusilbergehäuse, das dicht durch Beilegen von Dichtringen mit Stecker und Rahmen verbunden sein muß. Das Vergußloch ist durch ein aufgeklebtes Typenschild abgedeckt.

Gleichfalls im Handel erhältliche Entstörfilter benutzen ein gelötetes Mantelrohr aus Weißblech, wobei die elektrischen Bauelemente auf einer Trägerplatte montiert werden, die anschliessend am Stecker angenietet wird. Das Anlöten des Masseanschlusses erfolgt durch ein Loch im Mantelrohr, das vorher auf den Stecker aufgeschoben werden muß. Die Lötstelle wird durch ein Typenschild abgedeckt. Der Verguß der elektrischen Bauelemente erfolgt dabei von der offenen Rückseite des Mantelrohres her.

Durch die EP-0 025 367 AI ist schließlich ein elektrisches Verbindungselement mit mehreren Filtereinsätzen bekannt, durch dessen Stirnenden elektrische Ein- und Ausgangselemente geführt und die einzelnen Filterelemente leitend mit einer Grundplatte verbunden sowie elektrische Überschläge untereinander verhindert werden sollen. Zu diesem Zweck ist eine spezielle Anordnung von Federkontakten auf einer Grundplatte und eine Ummantelung mittels einer dielektrischen Schicht vorgesehen.

Die Eingangselemente selbst liegen innerhalb einer Verlängerung des Filtergehäuses, während die elektrischen Ausgangselemente ungeschirmt außerhalb des Filtergehäuses angeordnet sind.

Die eingangsseitige Verlängerung des Gehäuses ist dabei erweitert und dient als Adapter zur Aufnahme und Fixierung eines entsprechenden Steckergegenstücks. Die für eine wirksame Abschirmung jedoch wichtige Ausgangsseite des elektrischen Verbindungselements besitzt weder eine Verlängerung noch eine schachtartige Verjüngung des Filtergehäuses.

Der vorliegenden Erfindung liegt die Aufgabe zugrunde, ein Entstörfilter der eingangs genannten Art zu schaffen, das sich durch eine wirksame magnetische Schirmung und verbesserte Hochfrequenzeigenschaften auszeichnet, mit möglichst geringem Aufwand herstellbar ist und die an diese Filter gestellten nationalen und internationalen Vorschriften erfüllt.

Zur Lösung dieser Aufgabe sieht die Erfindung bei einem Filter gemäß Oberbegriff des Patentanspruchs vor, daß das Filtergehäuse verlängert und dabei schachtartig verjüngt ist, derart, daß die nach außen gekehrten Anschlußelemente mindestens eines Anschlusses geschirmt innerhalb des Filtergehäuses angeordnet sind.

Bereits durch die Verlängerung des Filtergehäuses wird eine Schirmung erzielt, die mindestens mit jener eines geschlossenen Filtergehäuses vergleichbar ist. Auch hinsichtlich Aufwand und Fertigungstechnik ist ein verlängertes Filtergehäuse einem völlig geschlossenen vorzuziehen. Soweit jedoch maximale Forderungen an die Schirmung gestellt werden, empfiehlt sich die vorstehend erwähnte Verwendung eines rohrförmigen Filtergehäuses z. B. aus Aluminium mit nur teilweise geschlossenen Stirnenden und einstückig an die offenen Stirnränder angesetzten Schächten. Besonders geeignet hierfür ist beispielsweise fließgepreßtes Aluminiumrohr, das mit wenig Aufwand herstellbar ist, außerdem eine gute elektrische Leitfähigkeit besitzt und die magnetischen Eigenschaften der Ringkerndrossel des Filters nicht beeinträchtigt. Das Filtergehäuse kann auch aus einem anderen elektrisch gut leitfähigen Material, wie z. B. Kupfer oder Messing, bestehen, durch das gleichfalls die Schirmwirkung, insbesondere bei tiefen Frequenzen, erhöht wird.

Vorteilhafterweise ist die Innenwandung des Filtergehäuses mindestens im Bereich der Verlängerung elektrisch isoliert; zu welchem Zweck beispielsweise ein Isolierstoffrahmen in die Verlängerung des Filtergehäuses eingesetzt sein kann, durch den die nach außen gekehrten Anschlußelemente gegen das Filtergehäuse isoliert sind. Durch diesen Isolierstoffrahmen, z. B. ein Kunststoffstück, das Kamine zur Aufnahme der äußeren Anschlußelemente, z. B. Flachstecker, Lötösen oder Anschlußlitzen, enthält, werden die Stirnseiten der Filtergehäuse so geschlossen, daß die Sicherheitsforderungen betreffend Kriechstrom- und Überschlagfestigkeit erfüllt und außerdem durch die vorgezogenen Filtergehäuseenden die äußeren Anschlußelemente vor unsachgemäßer Berührung geschützt sind.

Die Schirmung läßt sich noch weiter verbessern, wenn die Filtergehäuseinnenwände im Bereich der nach außen gekehrten Anschlußelemente durch einen Metallsteg überbrückt sind.

Die Schirmung läßt sich noch weiter verbessetn, wenn die Filtergehäuseinnenwände im Bareich der nach außen gekehtten Anschlußelemente durch einen Metallsteg überbrückt sind. Diese Überbtückung dürfte sich vor allem in den Fällen als vorteilhaft erweisen, bei denen die Filtergehäuse lediglich verlängert, also nicht schachtartig verjüngt sind.

Die vorstehend erwähnten Kunststoffeinsätze und dergl. können auch in ein in das Filtergehäuse eingesetztes Isolierstoffgehäuse integriert sein, in das die elektrischen Bauelemente, inbesondere Kondensatoren und Drosseln und die Anschlußelemente eingefügt und soweit erforderlich eingegossen sind. Dieses Isolierstoffgehäuse erfüllt in ausgezeichneter Weise die national und international geforderten Normen hinsichtlich der Luft- und Kriechwege zwischen den elektrischen Bauelementen und dem Filtergehäuse. Das Isolierstoffgehäuse hat z. B. getrennte Schächte für die Anschlüsse, z. B. Flachsteckeranschlüsse, und einen mit dem Isolierstoffgehäuse einstückig integrierten Steg zur Potentialtrennung für die Drossel. Eingespritzte Trennwände ermöglichen zudem den Einbau von nicht konfektionierten, d.h. nicht in Bechern angeordneten Kondensatoren und erleichtern die Montage der elektrischen Bauelemente. Das Isolierstoffgehäuse, als Träger der Bauelemente und Anschlüsse, kann vorab, also vor dem Einschub in das Filtergehäuse bestückt werden. Gleiches gilt für das Löten sämtlicher Anschlüsse, und das maschinell durchführbare Anwickeln der Drosselanschlußdrähte an die üblicherweise gestanzten Wrap-Stifte der Anschlüsse.

Bedingt durch das besonders gestaltete Filtergehäuse und die Verwendung eines durch Trennwände und dergl. unter= teilbaren Isolierstoffgehäuses genügt ein einmaliger Epoxidharz-Weichverguß der Filter. Durch dieses Isolierstoffgehäuse erübrigt sich auch eine ansonsten erforderliche Abdichtung der Bauelemente gegen das Filtergehäuse und die Anschlüsse.

Schließlich kann ein vorzugsweise über die gesamte Länge des Isolierstoffgehäuses geführter einzelner Schutzleiter vorgesehen sein, dessen Anschluß durch die Stirnwand des Filtergehäuses geführt und mit dem Filtergehäuse elektrisch leitend verbunden ist. Dieser Schutzleiter, der z. B. am Anschluß angenietet ist, erspart Montagezeiten. Er kann z. B. nach dem Aufschieben des Filtergehäuses auf das bestückte und vergossene Isolierstoffgehäuse an ein mittels Ultraschall auf die Filtergehäuse-Stirnwand aufgeschweißtes Kupferblech angelötet werden.

Die Erfindung wird nachstehend anhand von Ausführungsbeispielen erläutert. Es zeigt:

Fig. 1 eine Draufsicht auf ein Entstörfilter nach der Erfindung in teilweise geschnittener Darstellung,

Fig. 2 in teilweise geschnittener Darstellung eine Seitenansicht des Entstörfilters nach Fig. 1,

Fig. 3 einen Schnitt gemäß der Linie III-III nach Fig. 2,

Fig. 4 ein weiteres Ausführüngsbeispiel des Gegenstandes nach der Erfindung in der Darstellung nach Fig. 2, wobei gleiche Teile mit gleichen Bezugszeichen bezeichnet sind.

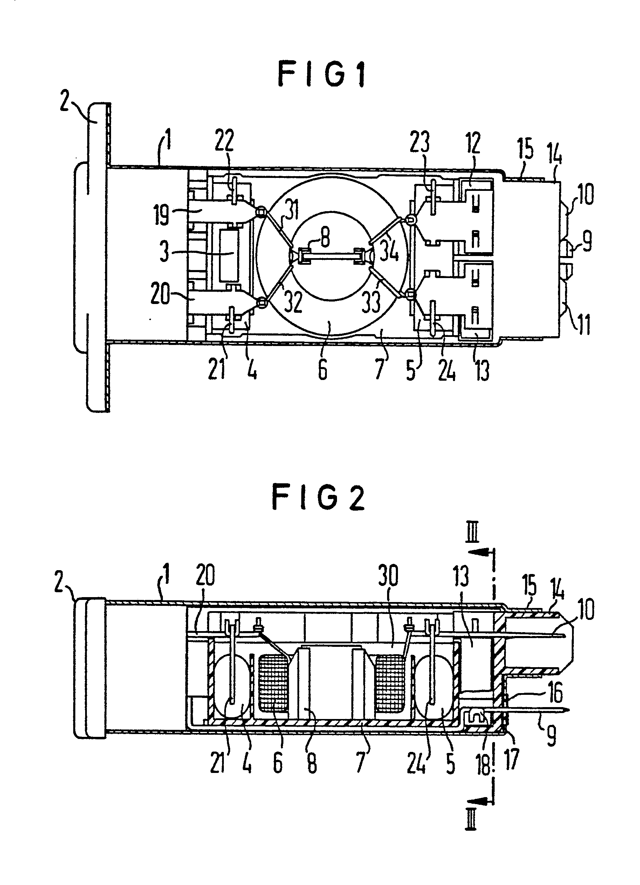

Das Entstörfilter nach Fig. 1 bis 3 besitzt ein Filtergehäuse 1, z. B. aus fließgepreßtem Aluminiumrohr, das an seinem einen Stirnende 15 schachtartig verjüngt und an seinem anderen Stirnende durch eine Steckerdose 2 geschlossen ist. In das Filtergehäuse 1 ist ein Isolierstoffgehäuse 7 eingesetzt, das z. B. durch Trennwände, die nicht näher bezeichnet sind, in Kammern unterteilt sein kann. In diese Kammern sind elektrische Bauelemente, z. B. ein elektrischer Widerstand 3, nicht konfektionierte elektrische Kondensatoren 4, 5, Y-Kondensatoren 12, 13 und eine Funkentstördrossel 6 eingesetzt, die auf einen einstückig an das Isolierstoffgehäuse 7 angeformten Potentialtrennungs-Steg 8 aufgeschoben ist. Die Enden 31, 32, 34 der Wicklungen der Drosselspule 6 sind - wie dies in Fig. 2 gezeigt ist - an entsprechend abgewinkelte Enden von Flachsteckern 10, 11, 19, 20 angewickelt und angelötet. Gleiches gilt für die Kondensatoren 4, 5 und 12, 13, die über Stege 21, 22, 23, 24 an die entsprechenden Enden der Flachstecker angeschaltet sind.

An die zum Stirnende 15 gekehrte Stirnfläche des Isolierstoffgehäuses 7 ist ein Schacht 14 einstückig angeformt, der mit seinen Außenflächen gegen die Innenflächen des Filtergehäuses anliegt. Die elektrischen Bauelemente und die an diese Bauelemente angeschalteten Flachstecker 10, 11, 19, 20 sind in Epoxidharz 30 eingebettet, wobei lediglich die nach außen gekehrten Teile der Flachstecker frei geführt sind.

Zusätzlich ist ein Schutzleiter 9 vorgesehen, der über die gesamte Länge des Isolierstoffgehäuses 7 geführt ist. Zur Kontaktierung dieses Schutzleiters mit dem Filtergehäuse ist im Bereich der Durchdringung des Schutzleiters durch die Stirnwand des Filtergehäuses 1 mittels Ultraschall eine Kupferplatte 17 auf das Filtergehäuse 7 aufgeschweißt. Die unmittelbare Kontaktierung des Schutzleiters 9 mit dieser Kupferplatte 17 erfolgt dabei über die bei 16 angedeutete Lötung.

Die Y-Kondensatoren 12, 13 sind unmittelbar zwischen Phase und Schutzleiter-Gehäuse angeordnet und mit dem Schutzleiter bei 18 kontaktiert. Durch diese äußerst kurzen Anschlußleitungen wird eine sehr induktivitätsarme Verbindung erzielt.

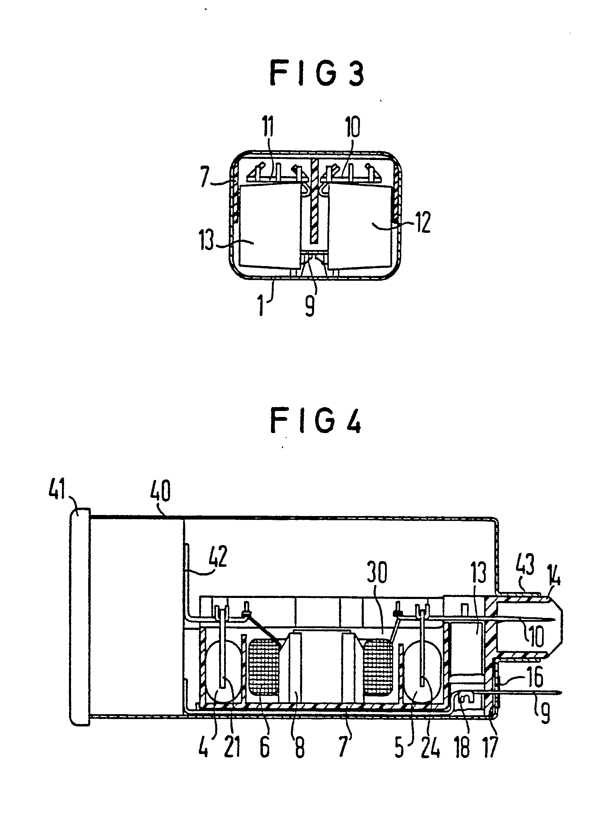

Das Ausführungsbeispiel nach Fig. 4 zeigt ein Entstörfilter mit im wesentlichen gleichem Aufbau. Ein weiterer Vorteil dieses Filters ist, daß es aufgrund seiner größeren Abmessungen auch für Filter mit Sicherungen verwendet werden kann. Das Filtergehäuse 40 ist gleichfalls stirnseitig durch eine Steckdose 41 bzw. durch eine durchbrochene Stirnwand abgeschlossen, an deren Durchbrechung ein Schacht 43 einstückig angeformt ist. Im Unterschied zum Ausführungsbeispiel nach Fig. 1 bis 3 sind die zur Steckdose gekehrten Flachstecker 42 abgewinkelt aus dem Isolierstoffgehäuse 7 herausgeführt.

## Patentansprüche

1. Elektrisches Entstörfilter mit einem Filtergehäuse (1, 40) mit an Stirnenden herausgeführten elektrischen Anschlüssen, die aus Anschlußelementen (10, 11), wie beispielsweise Flachsteckern, Anschlußlitzen, Stiftsteckern und dergleichen, bestehen und mit elektrischen Bauelementen, insbesondere Induktivitäten und Kapazitäten, die in das Filtergehäuse eingesetzt und an die elektrischen Anschlußelemente angeschaltet sind, dadurch gekennzeichnet, daß das Filtergehäuse (1, 40) verlängert und dabei schachtartig verjüngt ist, derart, daß die nach außen gekehrten Anschlußelemente (10, 11) mindestens eines Anschlusses geschirmt innerhalb des Filtergehäuses angeordnet sind.

2. Elektrisches Entstörfilter nach Anspruch 1, dadurch gekennzeichnet, daß die Innenwandung des Filtergehäuses (1, 40) im Bereich der Verlängerung elektrisch isoliert ist.

3. Elektrisches Entstörfilter nach Anspruch 1, dadurch gekennzeichnet, daß bei offenen Stirnenden des Filtergehäuses, diese im Bereich der nach außen gekehrten Anschlußelemente (10, 11) durch einen Metallsteg überbrückt sind.

4. Elektrisches Entstörfilter nach Anspruch 1, dadurch gekennzeichnet, daß in das Filtergehäuse (1, 40) ein Isolierstoffgehäuse (7) eingesetzt ist, in das die elektrischen Bauelemente (4, 5, 6, 12, 13) und die nach innen gekehrten Teile der Anschlüsse eingefügt und eingegossen sind.

5. Elektrisches Entstörfilter nach Anspruch 1, dadurch gekennzeichnet, daß ein vorzugsweise über die gesamte Länge des Isolierstoffgehäuses (7) geführter Schutzleiter (9) vorgesehen ist, dessen Anschluß durch die Stirnwand des Filtergehäuses (1, 40) geführt und mit dem Filtergehäuse elektrisch leitend verbunden ist.

## Claims

1. An electric interference suppression filter comprising a filter housing (1, 40), projecting from the ends of which are terminal elements (10, 11), such as for example, flat plugs, pigtails, pins or the like, and which encloses electrical components, in particular inductances and capacitances connected to the terminal elements, characterised in that the filter housing (1, 40) is elongate and tapers lengthwise in such manner that at least one of the outwards-facing terminal elements (10, 11) is screened inside an extension of the filter housing.

2. An electric interference suppression filter as claimed in Claim 1, characterised in that the inner wall of the filter housing (1, 40) is electrically insulated in the region of the extension.

3. An electric interference suppression filter as claimed in Claim 1, characterised in that any open front ends of the filter housing have a metal bridge in the region of the outwards-facing terminal elements (10, 11).

4. An electric interference suppression filter as claimed in Claim 1, characterised in that an insulating housing member (7) is inserted into the filter housing (1, 40) to hold electrical components (4, 5, 6, 12, 13) and the inwards-facing components of the terminals cast in position.

5. An electric interference suppression filter as claimed in Claim 1, <u>characterised in that</u> a protective conductor (9) is provded which preferably extends along the entire length of the insulating housing member (7) and the terminal of which leads through the end wall of the filter housing (1, 40) and is electricaliy connected to the filter housing.

## Revendications

1. Filtre électrique d'antiparasitage comportant un boîtier de filtre (1, 40) muni de bornes électriques, qui ressortent au niveau des extrémités frontales et sont constituées par des organes de raccordement (10, 11), comme par exemple des connecteurs plats, des cordons de raccordement, des connecteurs à broches et analogues, et comportant des composants électriques, notamment des inductances et des capacités, qui sont montées dans le boîtier de filtre et sont raccordées aux organes électriques de raccordement, caractérisé par le fait que le boîtier de filtre (1, 40) possède un prolongement et se rétrécit en forme d'embout, de telle sorte que les organes de raccordement (10, 11), qui sont tournés vers l'extérieur, d'au moins une borne sont disposés, en étant protégés, à l'intérieur du boîtier de filtre.

2. Filtre électrique d'antiparasitage selon la revendication 1, caractérisé par le fait que la paroi intérieure du boîtier de filtre (1, 40) est isolée du point de vue électrique dans la zone du prolongement.

3. Filtre électrique d'antiparasitage suivant la revendication 1, caractérisé par le fait que, lorsque les extrémités frontales du boîtier de filtre sont ouvertes, elles sont recouvertes par une barrette métallique, dans la zone des organes de raccordement (10, 11) tournés vers l'extérieur.

4. Filtre électrique d'antiparasitage suivant la revendication 1, caractérisé par le fait que dans le boîtier de filtre (1, 40) se trouve inséré un boîtier en matériau isolant (7), dans lequel les composants électriques (4, 5, 6, 12, 13) et les éléments, tournés vers l'intérieur, des bornes sont insérsés et renfermés.

5. Filtre électrique d'antiparasitage suivant la revendication 1, caractérisé par le fait qu'il est prévu un conducteur de protection (9) qui est guidé de préférence sur toute la longueur du boîtier en matériau isolant (7) et dont le raccord traverse la paroi frontale du boîtier de filtre (1, 40) et est relié d'une manière électriquement conductrice à ce boîtier de filtre.

# FIG 1

# FIG 2

# FIG 3

# FIG 4